# EUROPÄISCHE PATENTSCHRIFT

(11) **EP 2 692 216 B1**
(45) Veröffentlichungstag und Bekanntmachung des Hinweises auf die Patenterteilung: **21.11.2018**
(21) Anmeldenummer: 12709510.7
(22) Anmeldetag: 07.03.2012
(51) Int. Cl.: H05K 7/14

(54) **UMRICHTERANORDNUNG, VERFAHREN ZUM HERSTELLEN EINER UMRICHTERANORDNUNG UND VERFAHREN ZUM BETREIBEN EINER UMRICHTERANORDNUNG**
CONVERTER ASSEMBLY, METHOD FOR PRODUCING A CONVERTER ASSEMBLY AND METHOD FOR OPERATING A CONVERTER ASSEMBLY
ENSEMBLE CONVERTISSEUR, PROCÉDÉ POUR FABRIQUER UN ENSEMBLE CONVERTISSEUR ET PROCÉDÉ POUR FAIRE FONCTIONNER UN ENSEMBLE CONVERTISSEUR

(30) Priorität: 28.03.2011 DE 102011015327
(43) Veröffentlichungstag der Anmeldung: 05.02.2014
(73) Patentinhaber: Sew-Eurodrive GmbH & Co. KG, 76646 Bruchsal (DE)
(72) Erfinder: NIKOLA, Joachim, 76703 Kraichtal (DE); KOLLAR, Hans Jürgen, 76646 Bruchsal (DE); JANZER, Rolf, 76646 Bruchsal (DE); MAUCHER, Jürgen, 76359 Marxzell - Schielberg (DE); WETZEL, Thomas, 76698 Ubstadt-Weiher (DE)
(86) Internationale Anmeldenummer: PCT/EP2012/001006
(87) Internationale Veröffentlichungsnummer: WO 2012/130378

(56) Entgegenhaltungen:
- EP-A2- 0 994 559
- US-A- 5 666 268
- US-A1- 2006 136 622
- "Lageregelung", wikipedia , 6. Oktober 2009 (2009-10-06), XP002681576, Gefunden im Internet: URL:http://web.archive.org/web/20091006154 647/http://de.wikipedia.org/wiki/Lageregel ung [gefunden am 2012-08-09]

## Beschreibung

Die Erfindung betrifft eine Umrichteranordnung, und ein Verfahren zum Betreiben einer Umrichteranordnung. Aus der EP 0 994 559 A2ist ein modular aufgebauter Umrichter gezeigt, bei dem ein Leistungsteil mit aufsetzbarem Steuerkopf und darin einsetzbarem Handbediengerät vorgesehen ist.

Aus der US 2006/136622 A1 ist ein modular oder kaskadiert aufgebautes Steuerverfahren bekannt.

Aus der US 5 666 268 A ist eine elektronisch variable Geschwindigkeitsregelung bei einem Antrieb bekannt.

Der Erfindung liegt daher die Aufgabe zugrunde, ein kostengünstiges Verfahren zum Herstellen einer Umrichteranordnung zu erreichen, wobei eine hohe Varianz an Funktionalität applikationsbedingt gefordert ist.

Erfindungsgemäß wird die Aufgabe bei der Umrichteranordnung nach den in Anspruch 1 und bei dem Verfahren zum Betreiben der Umrichteranordnung nach den in Anspruch 9 angegebenen Merkmalen gelöst.

Wichtige Merkmale der Erfindung bei der Umrichteranordnung sind, dass ein Basismodul Leistungselektronik und Steuerelektronik umfasst,
wobei das Basismodul ein Gehäuse aufweist, insbesondere ein für Leistungselektronik und Steuerelektronik zumindest teilweise gehäusebildendes Gehäuseteil,
wobei das Basismodul eine elektrische und mechanische Schnittstelle aufweist, über die eine Signalelektronik mit dem Basismodul formschlüssig und/oder kraftschlüssig verbindbar ist zur Bildung der Umrichteranordnung,
wobei die Signalelektronik ein Gehäuse aufweist, insbesondere so dass nach Verbindung das Gehäuse der Signalelektronik und das Gehäuse des Basismoduls gemeinsam ein Gehäuse der Umrichteranordnung bilden,
wobei über die Schnittstelle ein Sollwert für Drehzahl und/oder Drehmoment elektrisch übertragbar ist, wobei die Signalelektronik Mittel zum Empfangen, Bestimmen und/oder Eingeben des Sollwertes aufweist.

Von Vorteil ist dabei, dass die Umrichteranordnung und der Baukasten zu deren Herstellung mit einem Basismodul ausführbar ist, welches einen Umrichter eingeschränkter Funktionalität, nämlich nur die Regelung auf den Drehmoment- oder Drehzahl-Sollwert, darstellt. Eingabemittel oder Anzeigemittel sind dabei verzichtbar. Somit ist je nach Applikationsanforderung des Umrichters in der vorgesehenen Anlage ein entsprechendes Signalelektronik-Modul mit dem Basismodul verbindbar, so dass die gewünschten Funktionalitäten verfügbar sind, insbesondere Eingabe und Anzeigemöglichkeiten für den Bediener und/oder gewünschte Sorte der Datenschnittstelle zu verbundenen Geräten.

Bei einer vorteilhaften Ausgestaltung weist die Signalelektronik eine Regeleinheit auf, die aus einer Abweichung zwischen einem Sollwert einer Größe, insbesondere einer Position, und einem Istwert einen Stellwert bestimmt, der als Sollwert für Drehzahl beziehungsweise als Sollwert für Drehmoment über die Schnittstelle an die Steuerelektronik übermittelt wird, und/oder weist die Signalelektronik eine Positioniersteuerung auf, welche als Stellgröße einen Stellwert bestimmt, der als Sollwert für Drehzahl beziehungsweise als Sollwert für Drehmoment über die Schnittstelle an die Steuerelektronik übermittelt wird. Von Vorteil ist dabei, dass eine übergeordnete Regelung in der Signalelektronik ausführbar ist, so dass der von dieser Regeleinheit bestimmte Stellwert an die Steuerelektronik übermittelbar ist. Die Art der übergeordneten Regelung ist dabei applikationsabhängig wählbar.

Bei einer vorteilhaften Ausgestaltung weist die Steuerelektronik eine Regeleinheit auf, die aus einer Abweichung zwischen dem von der Signalelektronik zugeführten Sollwert und dem Istwert einen Stellwert für Motorspannung bestimmt und entsprechende pulsweitenmodulierte Ansteuersignale für die Leistungshalbleiter der Leistungselektronik erzeugt, welche zur Erzeugung der zu stellenden Motorspannung entsprechend ansteuerbar sind. Von Vorteil ist dabei, dass eine einfache und schnelle Regelung des Motors ermöglicht ist.

Bei einer vorteilhaften Ausgestaltung weist eine oder jede Regeleinheit einen linearen Regler, insbesondere PI-Regler mit oder ohne Vorsteuerung, auf. Von Vorteil ist dabei, dass eine schnell wirksame, effektive, wenig rechenaufwendige Regelung ermöglicht ist.

Bei einer vorteilhaften Ausgestaltung weist die Signalelektronik Mittel zur Eingabe und/oder Anzeige von Parametern, insbesondere einen berührungssensitiven Bildschirm, und/oder Anschlussvorrichtungen für elektrische Leitungen, insbesondere Signalleitungen oder Leistungskabelleitungen, auf. Von Vorteil ist dabei, dass eine applikationsgerechte Signalelektronik einsetzbar ist.

Bei einer vorteilhaften Ausgestaltung weist die Signalelektronik eine Feldbusschnittstelle auf. Von Vorteil ist dabei, dass die Schnittstelle applikationsabhängig ausgeführt ist.

Eine Umrichteranordnung kann aus einem Baukasten hergestellt werden, welcher zueinander unterschiedliche Basismodule und zueinander unterschiedliche Signalelektronik-Module aufweist,
wobei jedes Basismodul mit jedem Signalelektronik-Modul über die Schnittstelle elektrisch und mechanisch verbindbar ist,
insbesondere wobei verschiedenartige Leistungselektronik-Module für das Herstellen des Basismoduls vorgesehen sind, wobei eine entsprechende elektrische und mechanische Schnittstelle zwischen Leistungselektronik und Steuerelektronik vorgesehen ist,
wobei Varianten von Umrichteranordnungen verschiedener Funktionalität aus den Basismodulen und Signalelektronik-Modulen zusammengesetzt werden, insbesondere je nach Applikationsanforderung.

Von Vorteil ist dabei, dass abhängig von der jeweiligen Applikation und den dortigen Anforderungen eine Umrichteranordnung zusammenfügbar und herstellbar ist, welche den Anforderungen genügt, insbesondere also die geeignete Datenschnittstelle und/oder ein-Ausgabemittel aufweist.

Wichtige Merkmale bei dem Verfahren zum Betreiben einer Umrichteranordnung sind, dass von einer Signalelektronik ein Sollwert für Drehmoment oder Drehzahl über eine Schnittstelle einer Steuerelektronik zugeführt wird,
wobei der Steuerelektronik der erfasste Wert für Motorstrom und/oder Winkelwert der Rotorwelle zugeführt wird und daraus ein Istwert für Drehmoment beziehungsweise Drehzahl bestimmt wird, welcher von einer Regeleinheit der Steuerelektronik auf den Sollwert hingeregelt wird, indem die Motorspannung als Stellwert bestimmt wird, insbesondere durch Bestimmen entsprechender pulsweitemodulierter Ansteuersignale, welche Leistungshalbleiterschaltern zugeführt werden,
wobei der Sollwert für Drehmoment beziehungsweise Drehzahl durch eine Regeleinheit der Signalelektronik bestimmt wird als Stellwert einer Stellgröße der Regeleinheit der Signalelektronik,
wobei der Signalelektronik ein Sollwert und ein Istwert einer Größe, insbesondere einer Position eines vom von der Umrichteranordnung gespeisten Motor angetriebenen Teils, zugeführt wird und die Abweichung zwischen Sollwert und Istwert bestimmt wird und daraus der Stellwert bestimmt wird von der Regeleinheit der Signalelektronik. Von Vorteil ist dabei, dass eine applikationsgerechte übergeordnete Regelung in der Signalelektronik vorsehbar ist, wobei der zugehörige Mikrocontroller oder Mikroprozessor der Signalelektronik entsprechend gewählt ist. Dadurch ist vorteiligerweise keine zusätzliche Belastung für den Mikrocontroller oder Mikroprozessor der Steuerelektronik bewirkt. Insbesondere ist die Steuerelektronik von ihrer Rechenleistung und Speicherkapazität her auf die Anforderungen der Drehzahlregelung oder Drehmomentregelung entsprechend dimensionierbar. Die Signalelektronik ist auf die applikationsspezifischen Anforderungen, wie beispielsweise eine große Speicherkapazität für Ablaufprogramme in der Positioniersteuerung entsprechend dimensionierbar.

Bei einer vorteilhaften Ausgestaltung weist die oder jede Regeleinheit einen linearen Regler, insbesondere P-Regler, PI-Regler oder PID-Regler, mit oder ohne Vorsteuerung auf. Von Vorteil ist dabei, dass ein einfach zu programmierender Regler verwendbar ist.

Wichtige Merkmale bei der Drehmomentschnittstelle oder der Drehzahlschnittstelle zwischen einer Signalelektronik und einer Steuerelektronik sind, dass jeweils beide einen Rechner, insbesondere Mikrocontroller oder Mikroprozessor, aufweisen,
wobei die Steuerelektronik ein Basismodul mit einer Leistungselektronik bildet und beide Rechner als Reglereinheit fungieren,
wobei die Reglereinheit der Steuerelektronik als Drehmomentregler beziehungsweise Drehzahlregler fungiert und die Reglereinheit der Signalelektronik als übergeordneter Regler, welcher als Stellgröße die Sollwertvorgabe über die Drehmomentschnittstelle beziehungsweise Drehzahlschnittstelle der Reglereinheit der Steuerelektronik zur Verfügung stellt.

Von Vorteil ist dabei, dass jede Elektronik an die gestellten Anforderungen anpassbar ist und keine Überkapazitäten bereit gestellt werden müssen. Außerdem ist die Sicherheit erhöht, da Ausfälle einer einfachen übersichtlicheren Struktur unwahrscheinlicher sind.

Die Erfindung wird nun anhand von schematischen Abbildungen näher erläutert:

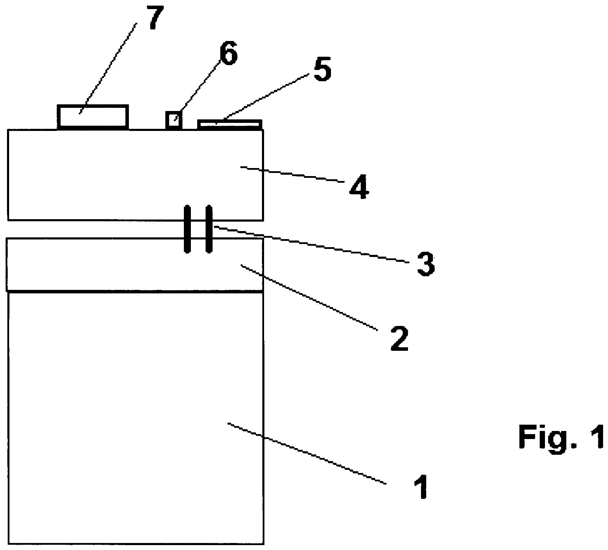

In der Figur 1 ist ein erfindungsgemäßer Umrichter schematisch skizziert.

Der Umrichter weist eine Leistungselektronik 1 auf, die mit einer Steuerelektronik 2 verbunden ist. Über eine Schnittstelle 3, insbesondere die als Steckverbindung ausführbar ist oder eine solche umfasst, ist ein Datenaustausch mit einer aufsetzbaren Signalelektronik 4 ermöglicht.

Dabei wird von der Signalelektronik 4 ein Drehmomentsollwert oder ein Drehzahlsollwert an die Steuerelektronik übermittelt.

Die Steuerelektronik 2 weist eine Regeleinheit auf, welcher dieser Sollwert zugeführt wird. Außerdem erzeugt die Regeleinheit pulsweitenmodulierte Ansteuersignale für die Leistungshalbleiter der Leistungselektronik 1. Dabei weist die Leistungselektronik einen Gleichrichter auf, dem aus dem Versorgungsnetz Wechselspannung zugeführt wird. Die vom Gleichrichter erzeugte Gleichspannung wird einem Kondensator zugeführt, aus dem die Endstufe der Leistungselektronik gespeist wird, welche die in Halbbrücken angeordneten Leistungshalbleiterschalter aufweist. Aus der Endstufe wird ein Elektromotor, vorzugsweise ein Drehstrommotor mit Motorphasenzuleitungen (U, V, W) gespeist. Der zum Motor fließende Strom wird mittels Sensoren oder in den Halbbrücken angeordneten Shuntwiderständen erfasst, wobei der einer jeden Motorphasenleitung zugeordnete Motorphasenstrom erfasst wird. Alternativ ist auch in einem vom Kondensator ausgehenden Strompfad ein Shuntwiderstand anordenbar, der abhängig von den Schaltzuständen abgefragt wird. Aus den erfassten Motorphasenstromwerten wird ein Motorstromraumzeiger gebildet und von der Regeleinheit als Istwert auf einen Sollwert hin geregelt. Stellgröße der Regelstrecke ist dabei die durch die pulsweitenmodulierte Ansteuersignale erzeugte Motorspannung, also der Motorspannungsraumzeiger.

Bei einer ersten erfindungsgemäßen Ausführung wird der Regeleinheit als Sollwert ein Drehzahlwert zugeführt. Entweder wird der Istwert der Drehzahl aus der zeitlichen Veränderung des erfassten Motorstromraumzeigers bestimmt oder es ist am Motor ein Drehzahlsensor angeordnet, der den Istwert der Drehzahl der Rotorwelle des Motors erfasst und dem Umrichter zuführt. Aus der Abweichung des Istwertes der Drehzahl vom Sollwert wird von der Regeleinheit, welche beispielsweise einen linearen Regler umfasst, ein Ausgangssignal bestimmt, welches zum Stellen der Motorspannung verwendet wird. Hierzu werden aus dem Ausgangssignal die pulsweitenmodulierten Ansteuersignale bestimmt, so dass die Motorspannung auf den bestimmten Stellwert gestellt wird.

Bei einer zweiten erfindungsgemäßen Ausführung wird der Regeleinheit als Sollwert das Drehmoment zugeführt. Ein unter Verwendung des erfassten Motorstromraumzeigers bestimmter Drehmoment-Istwert wird verwendet, um die Abweichung des Istwerts des Drehmoments vom Sollwert des Drehmoments zu bestimmen. Aus der Abweichung wird von der Regeleinheit welche beispielsweise einen linearen Regler umfasst, ein Ausgangssignal bestimmt, welches zum Stellen der Motorspannung verwendet wird. Hierzu werden aus dem Ausgangssignal die pulsweitenmodulierten Ansteuersignale bestimmt, so dass die Motorspannung auf den bestimmten Stellwert gestellt wird.

Das Leistungsteil 1 samt Steuerelektronik 2 stellt also an sich schon einen Umrichter dar, dem über die Schnittstelle zwischen Steuerelektronik 2 und Signalelektronik 4 ein Drehzahl- und/oder Drehmoment-Sollwert vorgegeben wird und der dann die Motorspannung derart stellt, dass der jeweilige Istwert auf den vorgegebenen Sollwert hingeregelt wird. Das Leistungsteil 1 umfasst also einen Drehzahlregler und/oder Drehmoment-Regler.

Das Leistungsteil 1 samt Steuerelektronik 2 ist derart zusammengefügt, dass die beiden Komponenten ein Elektrogerät mit Gehäuse bilden.

Auf oder in das gebildete Elektrogerät wird die Signalelektronik 4 angefügt, insbesondere wobei die elektrischen Verbindungen zwischen Signalelektronik 4 und Steuerelektronik 2 mittels Steckverbindung hergestellt werden. Alternativ ist auch eine berührungslose Übertragung - beispielsweise über Funkwellen oder Infrarotwellen - ermöglicht.

Die Signalelektronik 4 weist Anschlussvorrichtungen zum Anschließen einer Feldbusverbindung, insbesondere Ethernet-Bus, CAN-Bus, Devicenet-Bus, Profibus oder Interbus, auf. Somit sind Daten übertragbar von und/oder zu anderen über die Feldbusverbindung verbundenen Geräten, wie beispielsweise ein übergeordneter Rechner.

Außerdem weist die Signalelektronik 4 an ihrer Außenseite, welche gehäusebildend ausgeführt ist, ein Anzeigemittel 5, ein Eingabemittel 6 und/oder ein berührungssensitives Anzeigemittel 7 auf. Somit sind also Parameter, insbesondere auch Sollwerte, eingebbar oder über die Feldbusverbindung empfangbar und von der Signalelektronik 4 über die Schnittstelle an die Steuerelektronik 2 weiterleitbar.

Die Signalelektronik 4 weist nicht nur ein Anzeigemittel 5, ein Eingabemittel 6, ein berührungssensitives Anzeigemittel 7 sondern auch Anschlussvorrichtungen zum Anschließen von Leistungsleitungen, Feldbusverkabelung, Lichtleitern und/oder Signalleitungen auf.

Infolge der geschaffenen Schnittstelle zwischen Steuerelektronik 2 und Signalelektronik 4 ist ein modularer Aufbau möglich, also ein einfacher und schneller Austausch der Signalelektronik 4 gegen eine andere Signalelektronik 4, welche sich in Funktionen und/oder Eingabemittel und/oder Ausgabemittel unterscheidet und/oder keine Anschlussvorrichtungen aufweist. Entsprechend ist auch das Leistungsteil gegen ein anderes Leistungsteil, beispielsweise gegen ein Leistungsteil höherer Leistung und/oder für eine einphasige Versorgung statt einer dreiphasigen Versorgung, austauschbar, da zwischen Steuerelektronik 2 und Leistungselektronik 1 eine entsprechende Schnittstelle vorhanden ist. Somit ist mit einer geringen Anzahl an Komponenten eine hohe Varianz an Umrichtern herstellbar. Die Komponenten bilden dabei einen Baukasten, aus dem je nach Bedarf die entsprechende Komponente auswählbar ist und damit ein jeweiliger Umrichter der gesamten Umrichter-Baureihe hergestellt wird.

Somit ist statt oder zusätzlich zu der genannten Feldbusschnittstelle der Signalelektronik 4 eine weitere Busschnittstelle und/oder Datenschnittstelle für Datenaustausch mit einem Rechner bei einer jeweiligen Signalelektronik 4 des Baukastens vorsehbar.

Im Baukasten ist also eine Signalelektronik 4 vorgesehen, die eine Schnittstelle zu einem erste Bussystem, beispielsweise CAN-Bus, aufweist und eine andere Signalelektronik 4, welche eine Schnittstelle zu einem zweiten Bussystem aufweist, beispielsweise Profibus.

Weiterhin ist auch eine Signalelektronik 4 vorsehbar, welche erweiterte Funktionalitäten aufweist, wie beispielsweise ein übergeordnete Positioniersteuerung, die ein vom Motor zu bewegendes Teil auf eine Zielposition hin steuert, indem sei aus der erfassten Abweichung zwischen Istposition, welche aus einem die Istposition des Teils erfassenden entsprechenden Sensorsystem zugeführt wird, und Sollposition einen derartigen Drehzahlwert bestimmt und an die Steuerelektronik 2 übermittelt, dass das Teil auf die Zielposition hingeführt wird. Dabei umfasst die Signalelektronik 4 also auch einen Positionsregler, der die Istposition auf die zum jeweiligen Zeitpunkt vorgegebene Sollposition hinregelt, wobei der zeitliche Sollpositionsverlauf vorgebbar ist.

Dabei ist auch eine Ablaufsteuerung in die Positionssteuerung integrierbar, wobei Eingänge und Ausgänge für Sensoren und /oder Aktoren vorsehbar sind.

Am oder ins Gehäuse der Leistungselektronik sind auch weitere Module anbaubar, wie beispielsweise ein Lüftermodul, welches einen Kühlluftstrom entlang des Kühlkörpers der Leistungselektronik 1 strömen lässt und somit die Entwärmung verbessert.

Außerdem ist ein Bremswiderstandsmodul anbaubar, so dass im generatorischen Betrieb des Motors erzeugte Energie als Wärme abführbar ist an die Umgebung. Ebenso ist ein Netzfilter als Modul anbaubar, das die elektrischen Rückwirkungen auf das speisende Wechselstromnetz verbessert.

Vorzugsweise ist das Gehäuse der Signalelektronik 4 mit dem Gehäuse des Basismoduls dicht verbindbar ist, was allerdings in der Figur 1 nicht sichtbar dargestellt ist. Insbesondere ist also zwischen dem Gehäuse der Signalelektronik und dem Gehäuse des Basismoduls eine Dichtung, insbesondere O-Ringdichtung oder angespritzte Elastomer-Dichtung, angeordnet. Die Steckverbindung, also die elektrische und mechanische Schnittstelle zwischen Basismodul und Signalelektronik 4, ist im von den beiden Gehäusen abgedichtet und somit gehäusebildend umgebenen Raumbereich angeordnet. Somit ist Korrosion des die Schnittstelle realisierenden Steckverbinderteils und Gegensteckverbinderteils verhindert.

### Bezugszeichenliste

1 Leistungselektronik
2 Steuerelektronik
3 Schnittstelle, insbesondere Steckverbindung
4 Signalelektronik
5 Anzeigemittel
6 Eingabemittel
7 berührungssensitives Anzeigemittel

## Patentansprüche

1. Umrichteranordnung zur Speisung eines Elektromotors,
wobei ein Basismodul Leistungselektronik (1) und Steuerelektronik (2) umfasst,
wobei das Basismodul ein Gehäuse aufweist, insbesondere ein für Leistungselektronik (1) und Steuerelektronik (2) ganz oder zumindest teilweise gehäusebildendes Gehäuseteil,
**dadurch gekennzeichnet, dass**
das Basismodul eine elektrische und mechanische Schnittstelle (3) aufweist, über die eine Signalelektronik (4) mit dem Basismodul formschlüssig und/oder kraftschlüssig verbindbar ist zur Bildung der Umrichteranordnung,
wobei die Signalelektronik (4) ein Gehäuse aufweist, insbesondere so dass nach Verbindung das Gehäuse der Signalelektronik (4) und das Gehäuse des Basismoduls gemeinsam ein Gehäuse der Umrichteranordnung bilden,
wobei über die Schnittstelle (3) ein Sollwert für Drehzahl und/oder Drehmoment elektrisch übertragbar ist, wobei die Signalelektronik (4) Mittel zum Empfangen, Bestimmen und/oder Eingeben des Sollwertes aufweist,
- wobei die Signalelektronik (4) eine Regeleinheit aufweist, die aus einer Abweichung zwischen einem Sollwert einer Größe, insbesondere einer Position, und einem Istwert einen Stellwert bestimmt, der als Sollwert für Drehzahl beziehungsweise als Sollwert für Drehmoment über die Schnittstelle (3) an die Steuerelektronik (2) übermittelt wird,
- und/oder wobei die Signalelektronik (4) eine Positioniersteuerung umfasst, welche als Stellgröße einen jeweils aktuellen Stellwert bestimmt, der als Sollwert für Drehzahl beziehungsweise als Sollwert für Drehmoment über die Schnittstelle (3) an die Steuerelektronik (2) übermittelt wird.

2. Umrichteranordnung nach einem der vorangegangenen Ansprüche,
**dadurch gekennzeichnet, dass**
die Steuerelektronik (2) eine Regeleinheit aufweist, die aus einer Abweichung zwischen dem von der Signalelektronik (4) zugeführten Sollwert und dem Istwert einen Stellwert für Motorspannung bestimmt und entsprechende pulsweitenmodulierte Ansteuersignale für die Leistungshalbleiter der Leistungselektronik (1) erzeugt, welche zur Erzeugung der zu stellenden Motorspannung entsprechend ansteuerbar sind.

3. Umrichteranordnung nach einem der vorangegangenen Ansprüche,
**dadurch gekennzeichnet, dass**
das Basismodul, also die Steuerelektronik (2), einen Drehzahl- und/oder einen Drehmomentregler aufweist
und dass
die Signalelektronik (4) einen Positionsregler aufweist, dessen Ausgang ein Drehzahlsollwert oder Drehmomentsollwert ist, welcher über die mechanische Schnittstelle (3) dem Drehzahl- beziehungsweise Drehmoment-Regler im Basismodul, also in der Steuerelektronik (2), übertragen und vorgegeben wird.

4. Umrichteranordnung nach einem der vorangegangenen Ansprüche,
**dadurch gekennzeichnet, dass**
die Regeleinheit einen linearen Regler, insbesondere PI-Regler mit oder ohne Vorsteuerung, aufweist.

5. Umrichteranordnung nach einem der vorangegangenen Ansprüche,
**dadurch gekennzeichnet, dass**
die Signalelektronik (4) Mittel zur Eingabe und/oder Anzeige von Parametern, insbesondere einen berührungssensitiven Bildschirm, und/oder Anschlussvorrichtungen für elektrische Leitungen, insbesondere Signalleitungen oder Leistungskabelleitungen, aufweist.

6. Umrichteranordnung nach einem der vorangegangenen Ansprüche,
**dadurch gekennzeichnet, dass**
die Signalelektronik (4) eine Feldbusschnittstelle aufweist.

7. Umrichteranordnung nach einem der vorangegangenen Ansprüche,
**dadurch gekennzeichnet, dass**
die elektrische und mechanische Schnittstelle (3) als Steckverbindung ausgeführt ist, insbesondere wobei das Basismodul ein Steckverbinderteil und die Signalelektronik (4) ein entsprechendes Gegensteckverbinderteil aufweist.

8. Umrichteranordnung nach einem der vorangegangenen Ansprüche,
**dadurch gekennzeichnet, dass**
das Gehäuse der Signalelektronik (4) mit dem Gehäuse des Basismoduls dicht verbindbar ist, insbesondere also zwischen dem Gehäuse der Signalelektronik (4) und dem Gehäuse des Basismoduls eine Dichtung angeordnet ist,
wobei die mechanische Schnittstelle (3) im somit von den Gehäusen abgedichtet umgebenen Raumbereich angeordnet ist, insbesondere also von den Gehäusen gehäusebildend umgeben ist.

9. Verfahren zum Betreiben einer Umrichteranordnung nach mindestens einem der vorangegangenen Ansprüche,
wobei
von einer Signalelektronik (4) ein Sollwert für Drehmoment oder Drehzahl über eine Schnittstelle (3) einer Steuerelektronik (2) zugeführt wird,
wobei der Steuerelektronik (2) der erfasste Wert für Motorstrom und/oder Winkelwert der Rotorwelle zugeführt wird und daraus ein Istwert für Drehmoment beziehungsweise Drehzahl bestimmt wird, welcher von einer Regeleinheit der Steuerelektronik (2) auf den Sollwert hingeregelt wird, indem die Motorspannung gestellt wird, insbesondere indem entsprechende pulsweitemodulierte Ansteuersignale bestimmt werden, welche Leistungshalbleiterschaltern zugeführt werden,
**dadurch gekennzeichnet, dass**
die Signalelektronik (4) einen Stellwert für ein Drehmoment oder für eine Drehzahl auf der Basis der Abweichung zwischen einem Sollwert und einem Istwert bestimmt, und die Steuerelektronik den Istwert des Drehmoments bzw. der Drehzahl auf diesen Stellwert hinregelt,
wobei der Signalelektronik (4) ein Sollwert und ein Istwert einer Größe, insbesondere einer Position eines vom von der Umrichteranordnung gespeisten Motor angetriebenen Teils, zugeführt wird und die Abweichung zwischen Sollwert und Istwert bestimmt wird und daraus der Stellwert bestimmt wird von der Regeleinheit der Signalelektronik (4),
- wobei die Signalelektronik (4) eine Regeleinheit aufweist, die aus einer Abweichung zwischen einem Sollwert einer Größe, insbesondere einer Position, und einem Istwert einen Stellwert bestimmt, der als Sollwert für Drehzahl beziehungsweise als Sollwert für Drehmoment über die Schnittstelle (3) an die Steuerelektronik (2) übermittelt wird,
- und/oder wobei die Signalelektronik (4) eine Positioniersteuerung umfasst, welche als Stellgröße einen jeweils aktuellen Stellwert bestimmt, der als Sollwert für Drehzahl beziehungsweise als Sollwert für Drehmoment über die Schnittstelle (3) an die Steuerelektronik (2) übermittelt wird.

10. Verfahren nach mindestens einem der vorangegangenen Ansprüche, **dadurch gekennzeichnet, dass**
die oder jede Regeleinheit einen linearen Regler, insbesondere P-Regler, PI-Regler oder PID-Regler, mit oder ohne Vorsteuerung aufweist.

## Claims

1. Converter assembly for supplying power to an electric motor,
wherein a base module comprises power electronics (1) and control electronics (2),
wherein the base module has a housing, in particular a housing part which completely or at least partially forms a housing for power electronics (1) and control electronics (2),
**characterized in that**
the base module has an electrical and mechanical interface (3), via which signal electronics (4) can be connected to the base module with a form fit and/or with a force fit, in order to form the converter assembly,
wherein the signal electronics (4) have a housing, in particular such that, after connection, the housing of the signal electronics (4) and the housing of the base module together form a housing of the converter assembly,
wherein a setpoint value for rotational speed and/or torque can be transmitted electrically via the interface (3), wherein the signal electronics (4) have means for receiving, determining and/or inputting the setpoint value,
- wherein the signal electronics (4) have a control unit which, from a deviation between a setpoint value of a variable, in particular of a position, and an actual value, determines a manipulated value which is transmitted via the interface (3) to the control electronics (2) as the setpoint value for rotational speed and/or as the setpoint value for torque,
- and/or wherein the signal electronics (4) comprise a positioning controller which determines, as a manipulated variable, a respective current manipulated value which is transmitted via the interface (3) to the control electronics (2) as the setpoint value for rotational speed and/or as the setpoint value for torque.

2. Converter assembly according to one of the preceding claims,
**characterized in that**
the control electronics (2) have a control unit which, from a deviation between the setpoint value supplied by the signal electronics (4) and the actual value, determines a manipulated value for motor voltage and generates corresponding pulse-width-modulated actuation signals for the power semiconductors of the power electronics (4), which can be actuated accordingly to generate the motor voltage that is to be set.

3. Converter assembly according to one of the preceding claims,
**characterized in that**
the base module, that is to say the control electronics (2), has a rotational speed controller and/or a torque controller,
and **in that**
the signal electronics (4) have a position controller, the output of which is a rotational speed setpoint value or torque setpoint value which is transmitted via the mechanical interface (3) to the rotational speed controller or torque controller in the base module, that is to say in the control electronics (2), and is predefined.

4. Converter assembly according to one of the preceding claims,
**characterized in that**
the control unit has a linear controller, in particular a PI controller with or without pre-control.

5. Converter assembly according to one of the preceding claims,
**characterized in that**
the signal electronics (4) have means for inputting and/or displaying parameters, in particular a touch-sensitive screen, and/or connection devices for electric lines, in particular signal lines or power cable lines.

6. Converter assembly according to one of the preceding claims,
**characterized in that**
the signal electronics (4) have a fieldbus interface.

7. Converter assembly according to one of the preceding claims,
**characterized in that**
the electrical and mechanical interface (3) is embodied as a plug-in connection, in particular wherein the base module has a plug-in connector part and the signal electronics (4) have a corresponding mating plug-in connector part.

8. Converter assembly according to one of the preceding claims,
**characterized in that**
the housing of the signal electronics (4) can be sealingly connected to the housing of the base module, that is to say in particular a seal is arranged between the housing of the signal electronics (4) and the housing of the base module, wherein the mechanical interface (3) is arranged in the spatial area sealingly enclosed by the housings, that is to say in particular is enclosed by the housings in a housing-forming manner.

9. Method for operating a converter assembly according to at least one of the preceding claims,
a setpoint value for torque or rotational speed is supplied by signal electronics (4) to control electronics (2) via an interface (3),
wherein the detected value for motor current and/or the angle value of the rotor shaft is supplied to the control electronics (2) and an actual value for torque or rotational speed is determined therefrom, which is adjusted by a control unit of the control electronics (2) to the setpoint value by setting the motor voltage, in particular by determining corresponding pulse-width-modulated actuation signals which are supplied to power semiconductor switches,
**characterized in that**
the signal electronics (4) determine a manipulated value for a torque or for a rotational speed based on the deviation between a setpoint value and an actual value, and the control electronics adjust the actual value of the torque or rotational speed to this manipulated value,
wherein a setpoint value and an actual value of a variable, in particular of a position of a part that is driven by the motor to which power is supplied by the converter assembly, is supplied to the signal electronics (4), and the deviation between the setpoint value and the actual value is determined, and the manipulated value is determined therefrom by the control unit of the signal electronics (4),
- wherein the signal electronics (4) have a control unit which, from a deviation between a setpoint value of a variable, in particular of a position, and an actual value, determines a manipulated value which is transmitted via the interface (3) to the control electronics (2) as the setpoint value for rotational speed and/or as the setpoint value for torque,
- and/or wherein the signal electronics (4) comprise a positioning controller which determines, as a manipulated variable, a respective current manipulated value which is transmitted via the interface (3) to the control electronics (2) as the setpoint value for rotational speed and/or as the setpoint value for torque.

10. Method according to at least one of the preceding claims,
**characterized in that**
the or each control unit has a linear controller, in particular a P controller, PI controller or PID controller, with or without pre-control.

## Revendications

1. Ensemble variateur pour l'alimentation d'un moteur électrique,
dans lequel un module de base comprend une électronique de puissance (1) et une électronique de commande (2),
le module de base présentant un boîtier, en particulier une partie boîtier formant complètement ou au moins partiellement un boîtier pour l'électronique de puissance (1) et l'électronique de commande (2),
**caractérisé en ce que**
le module de base présente une interface électrique et mécanique (3) par l'intermédiaire de laquelle une électronique de signalisation (4) peut être reliée par engagement positif et/ou à force au module de base pour former l'ensemble variateur,
l'électronique de signalisation (4) présentant un boîtier, en particulier de sorte qu'après la liaison, le boîtier de l'électronique de signalisation (4) et le boîtier du module de base forment ensemble un boîtier de l'ensemble variateur,
une valeur de consigne de la vitesse de rotation et/ou du couple de rotation pouvant être transmise électriquement par l'intermédiaire de l'interface (3), l'électronique de signalisation (4) présentant des moyens pour recevoir, déterminer et/ou entrer dans la valeur de consigne,
- l'électronique de signalisation (4) présentant une unité de régulation qui détermine, à partir d'un écart entre une valeur de consigne d'une grandeur, en particulier d'une position, et une valeur réelle, une valeur de réglage qui est transmise à l'électronique de commande (2) par l'intermédiaire de l'interface (3) en tant que valeur de consigne de la vitesse de rotation ou en tant que valeur de consigne du couple de rotation,
- et/ou l'électronique de signalisation (4) comprenant une commande de positionnement qui détermine en tant que grandeur de réglage une valeur de réglage actuelle respective qui est transmise à l'électronique de commande (2) par l'intermédiaire de l'interface (3) en tant que valeur de consigne de la vitesse de rotation ou en tant que valeur de consigne du couple de rotation.

2. Ensemble variateur selon l'une des revendications précédentes,
**caractérisé en ce que**
l'électronique de commande (2) présente une unité de régulation qui détermine une valeur de réglage pour la tension de moteur à partir d'un écart entre la valeur de consigne fournie par l'électronique de signalisation (4) et la valeur réelle, et génère des signaux de commande modulés en largeur d'impulsion correspondants pour les semi-conducteurs de puissance de l'électronique de puissance (1), lesquels peuvent être commandés de manière correspondante pour générer la tension de moteur à régler.

3. Ensemble variateur selon l'une des revendications précédentes,
**caractérisé en ce que**
le module de base, c'est-à-dire l'électronique de commande (2), présente un régulateur de vitesse de rotation et/ou de couple de rotation
et que
l'électronique de signalisation (4) présente un régulateur de position dont la sortie est une valeur de consigne de vitesse de rotation ou une valeur de consigne de couple de rotation qui est transmise et prescrite au régulateur de vitesse ou de couple dans le module de base, c'est-à-dire dans l'électronique de commande (2), par l'intermédiaire de l'interface mécanique (3).

4. Ensemble variateur selon l'une des revendications précédentes,
**caractérisé en ce que**
l'unité de régulation présente un régulateur linéaire, en particulier un régulateur PI avec ou sans commande pilote.

5. Ensemble variateur selon l'une des revendications précédentes,
**caractérisé en ce que**
l'électronique de signalisation (4) présente des moyens pour entrer et/ou afficher des paramètres, en particulier un écran tactile, et/ou des dispositifs de connexion pour des lignes électriques, en particulier des lignes de signalisation ou des câbles de puissance.

6. Ensemble variateur selon l'une des revendications précédentes,
**caractérisé en ce que**
l'électronique de signalisation (4) présente une interface de bus de terrain.

7. Ensemble variateur selon l'une des revendications précédentes,
**caractérisé en ce que**
l'interface électrique et mécanique (3) est réalisée sous la forme d'une connexion enfichable, le module de base présentant en particulier une partie connecteur enfichable et l'électronique de signalisation (4) une partie connecteur enfichable complémentaire correspondante.

8. Ensemble variateur selon l'une des revendications précédentes,
**caractérisé en ce que**
le boîtier de l'électronique de signalisation (4) peut être relié de manière étanche au boîtier du module de base, en particulier un joint d'étanchéité étant disposé entre le boîtier de l'électronique de signalisation (4) et le boîtier du module de base,
dans lequel l'interface mécanique (3) est disposée dans la zone d'espace ainsi rendue étanche par les boîtiers, c'est-à-dire en particulier entourée par les boîtiers de manière à former un boîtier.

9. Procédé de fonctionnement d'un ensemble variateur selon au moins l'une des revendications précédentes,
dans lequel une valeur de consigne du couple de rotation ou de la vitesse de rotation est fournie par une électronique de signalisation (4) à une électronique de commande (2) par l'intermédiaire d'une interface (3),
dans lequel la valeur détectée du courant de moteur et/ou de la valeur angulaire de l'arbre de rotor est fournie à l'électronique de commande (2) et une valeur réelle du couple de rotation ou de la vitesse de rotation est déterminée à partir de celle-ci et régulée par une unité de régulation de l'électronique de commande (2) à la valeur de consigne en réglant la tension de moteur, en particulier en déterminant des signaux de commande modulés en largeur d'impulsion correspondants, lesquels sont fournis à des commutateurs à semi-conducteurs de puissance,
**caractérisé en ce que**
l'électronique de signalisation (4) détermine une valeur de réglage pour un couple ou pour une vitesse de rotation sur la base de l'écart entre une valeur de consigne et une valeur réelle, et l'électronique de commande régule la valeur réelle du couple ou de la vitesse de rotation à cette valeur de réglage,
une valeur de consigne et une valeur réelle d'une grandeur, en particulier d'une position d'une partie entraînée par le moteur alimenté par l'ensemble variateur étant fournies à l'électronique de signalisation (4), et l'écart entre la valeur de consigne et la valeur réelle étant déterminé et, à partir de celui-ci, la valeur de réglage étant déterminée par l'unité de régulation de l'électronique de signalisation (4),
- l'électronique de signalisation (4) présentant une unité de régulation qui détermine, à partir d'un écart entre une valeur de consigne d'une grandeur, en particulier d'une position, et une valeur réelle, une valeur de réglage qui est transmise à l'électronique de commande (2) par l'intermédiaire de l'interface (3) en tant que valeur de consigne de la vitesse de rotation ou en tant que valeur de consigne du couple de rotation,
- et/ou l'électronique de signalisation (4) comprenant une commande de positionnement qui détermine en tant que grandeur de réglage une valeur de réglage actuelle respective qui est transmise à l'électronique de commande (2) par l'intermédiaire de l'interface (3) en tant que valeur de consigne de la vitesse de rotation ou en tant que valeur de consigne du couple de rotation.

10. Procédé selon au moins l'une des revendications précédentes,
**caractérisé en ce que**
la ou chaque unité de régulation présente un régulateur linéaire, en particulier un régulateur P, un régulateur PI ou un régulateur PID, avec ou sans commande pilote.
